# EUROPEAN PATENT APPLICATION

(11) **EP 0 544 483 A1**
(43) Date of publication of application: **02.06.1993**
(21) Application number: 92310689.2
(22) Date of filing: 23.11.1992
(51) Int. Cl.: F16P 3/12, F16P 3/20, H03K 17/96

(54) **Electric tool with gripping sensors**

(30) Priority: 28.11.1991 IT MI913185
(71) Applicant: Black & Decker Inc., Newark Delaware 19711 (US)
(72) Inventor: Rosa, Carlo, I-22053 Lecco(Como) (IT); Ferragina, Rosario, I-22030 Lipomo(Como) (IT)
(74) Representative: Stagg, Diana Christine

(57) **Abstract**

A portable tool driven by an electric motor (25) comprises at least one grip on which is present a sensor (16) made of conductive material. The sensor is connected to an electronic circuit for operation, upon detection of a hand holding said grip, of means (22) of consent for the power supply of the motor through a manual power supply switch (13). The electronic circuit comprises a generator (18) sending a relatively high frequency signal to the input of means (19,20) of measurement of its amplitude. The sensor (16) is connected along the signal path between the generator (18) and measurement means (19,20) so as to induce a change in the signal when a hand approaches the grip. The measurement means sends an operation command to the consent means (22) upon detection of a lowering of the amplitude of the signal.

## Description

The present invention relates to a safety device for deactivation of an electric tool when the operator's hands leave predetermined positions thereon.

In the use of portable electric tools having parts with which contact is very dangerous for the operator, as for example circular or reciprocating saws, drills, polishers, etc., it is important that the operator keep his hands in predetermined positions identified by knobs or grips on the tool during the entire time of use of the tool both for a firm hold of the tool and for keeping the hands out of the dangerous zone. In addition, it is equally important that the tool not start if its power switch is inadvertently operated without first gripping the tool.

Devices have been proposed which prevent operation of the tool when the operator's hands do not grasp the tool correctly. In addition to preventing improper use of the tool these devices have the advantage of deactivating the tool if it is dropped by the operator, thus avoiding imaginable consequences.

Unfortunately the safety devices proposed heretofore have disadvantages which considerably limit their effectiveness and convenience of use. For example there have been proposed safety devices in which spaced strips of conductive material are placed on the tool grip and connected to a circuit for detecting the electrical resistance between said strips. Upon gripping the tool the operator's hands form a bridge with relatively low resistance between the conductive strips and the detection circuit permits operation of the tool. The tool is again deactivated by the circuit if an increase in resistance between the conductive strips is detected and which is caused by release of the grip by the operator.

An example of such a device is described in U.S. patent 4,132,902 where two conductive strips are applied on two opposite sides of a tool grip and connected to a circuit which closes an electric power contact of the tool when the resistance between the conductive strips is lowered by contact with the operator's hand.

The solution suffers from the serious defect that the tool must be used with bare hands to afford the required resistance variation between the conductive strips. But it is often preferable to use protective gloves, especially with a tool such as a circular saw polisher or hedge trimmer which can project incandescent material or chips during use. Additionally, in different countries there are regulations for various situations which require the use of protective gloves to provide greater safety.

Another defect in devices of the known art is that sometimes it is sufficient merely to reposition correctly the hands of the user on the handles of the tool to restart it. Even though there is usually another on/off switch for the tool, such as a trigger on the grip, it can cause potentially dangerous situations. For example, the tool may be started quite correctly by positioning of the hands and operation of the switch. If the tool is subsequently dropped, it should then turn itself off, even if the switch remains locked on. If, however, the operator grasps the tool to pick it up again and the tool starts suddenly, then there is clearly a risk for the operator.

The general purpose of the present invention is to obviate the above shortcomings by supplying a safety device incorporated in portable tools which would start the tool only if the hands, even wearing gloves, are correctly positioned on the grip. In addition accidental starting of the tool should be prevented once the correct hand positions are abandoned from the grip.

In accordance with the present invention, there is provided a portable tool driven by an electric motor of the type comprising at least one grip on which is present at least one sensor made of conductive material connected to an electronic circuit for operation, upon detection of a hand holding said grip, of means of consent for power supply to the motor through a manual power supply switch, characterized in that the electronic circuit comprises a generator sending a relatively high frequency signal to the input of means of measurement of its amplitude, the sensor being connected along the signal path between the generator and the input of measurement means so as to induce transfer of part of the signal upon a hand holding the grip near the sensor element, the measurement means sending an operation command to the consent means upon detection of a lowering of the amplitude of the signal produced by said transfer.

Preferably, the electronic circuit further comprises means of inhibition of activation of said consent means, said inhibition means becoming activated when said manual switch is activated and upon detection of a rise in the amplitude of the signal following said lowering.

The consent means may comprise a relay with exchange contacts in series with the motor power supply and which relay closes upon receipt of said operation command.

Said measurement means preferably comprises a detector to which is applied the generator signal and supplying at the output a direct voltage which is a function of the amplitude of said signal, said direct voltage being applied to a comparator together with a predefined threshold voltage, said comparator supplying said operation command to the consent means when said direct voltage passes said threshold voltage.

Said function is preferably inverse so as to supply said direct voltage in inverse proportion to the amplitude of the applied signal and so that said comparator supplies said operation command when said direct voltage exceeds said threshold voltage. The sensor may comprise in series, an RC shunt network, a negative half-wave rectifier and an RC integration network. Moreover, the comparator may be an operational amplifier with its negative input connected to said inversely proportional direct voltage and its positive input connected to said predefined direct threshold voltage.

Preferably, the inhibition means comprises a variation circuit for the predefined threshold voltage to take it outside the limits of said direct voltage. preferably the variation circuit comprises a hysteresis network for the comparator. The hysteresis network may comprise a feedback resistor arranged between the operational amplifier output and its positive input.

Preferably, means for braking the motor are provided which means are activated by the absence of the consent means operation command. Indeed, the braking means may be provided by the relay exchange contacts closing upon cessation of power supply thereto, and short circuiting the windings of the closed ring motor to generate braking forces by means of counter electromotive force.

To further clarify the explanation of the innovative principles of the present invention and its advantages as compared with the known art there is described below with the aid of the annexed drawings a possible embodiment as a nonlimiting example applying said principles. In the drawings:-
Figure 1 shows schematically a perspective view of a tool applying the innovative principles claimed here; and,
Figure 2 is a circuit diagram of an electrical arrangement providing a safety device in accordance with the present invention.

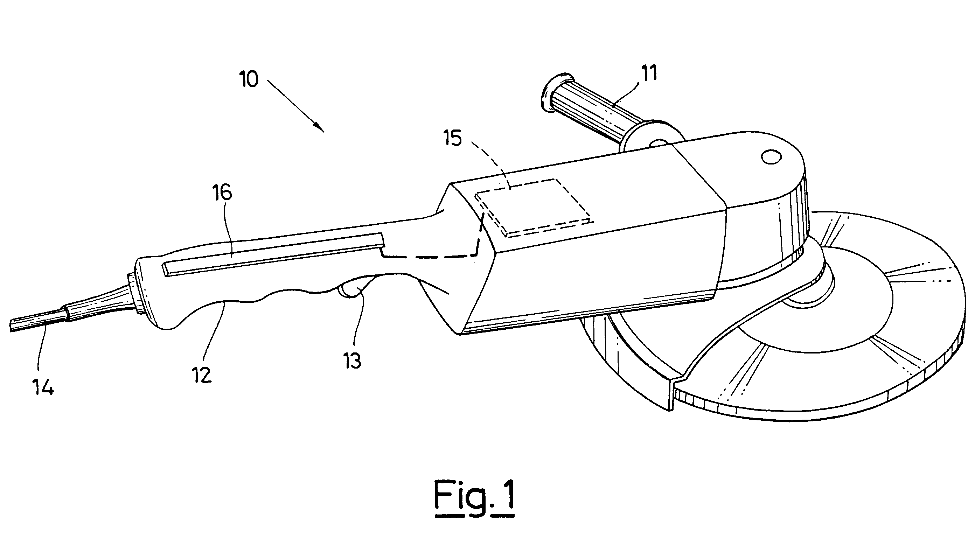

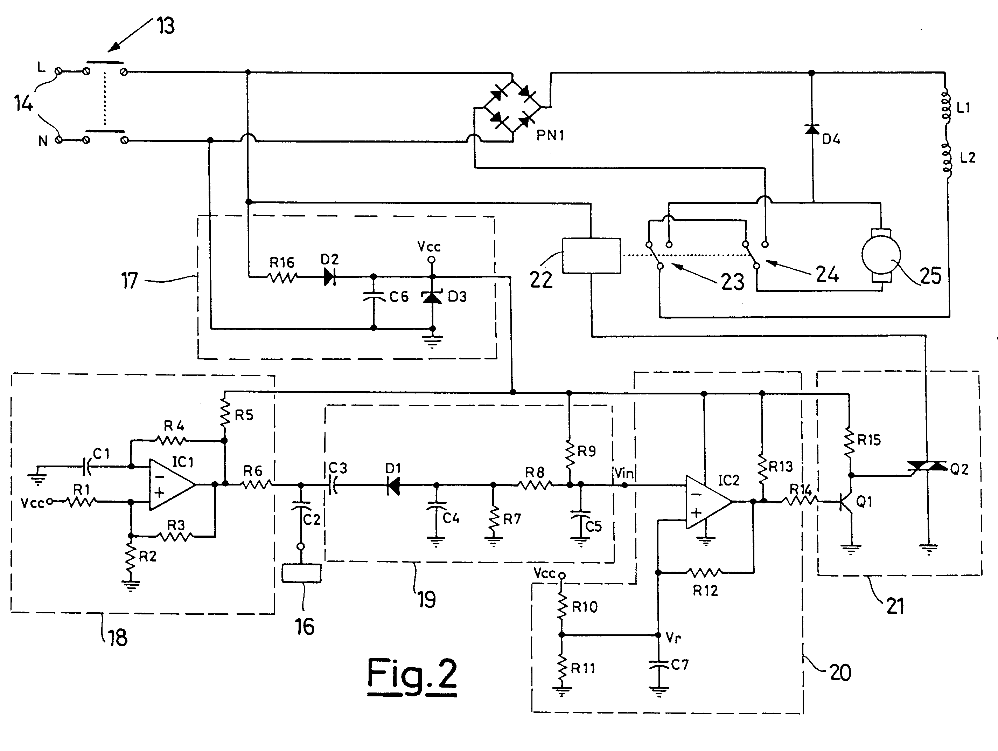

With reference to Figures 1 and 2, a portable tool such as an angle grinder 10 comprises grips 11,12 and an operating switch 13, e.g. provided in the form of a trigger on the main grip 12.

Power supply for the tool arrives through an electric cable 14 and, as will be clarified below, is sent to the electric motor of the tool through the switch 13 and an innovative safety device 15 controlled by a sensor 16 provided in the form of a metallic or in any case conductive plate or strip positioned on the grip 16 and optionally also insulated from the outside. Figure 2 shows an electric circuit providing the device 15.

As may be seen in Figure 2, electric power from the mains supply (not shown) reaches the tool through the cable 14 and is applied to the main switch 13 which, upon operation, supplies power to the circuits inside the tool. In particular, there is a circuit 17 which transforms the power supply, e.g. 220/240V 50Hz, into low direct current, e.g. 12V, which is then sent to supply the remaining electronic circuits of the device as Vcc.

Said circuits comprise a signal generator 18 having relatively high frequency, e.g. 500 kHz, sending the signal produced to a detecting circuit 19 which supplies the detected signal to a comparator circuit 20 which compares the level of the detected signal with a reference level to emit a control signal which is a function of said comparison.

The control signal output from the comparator is applied to an amplifier circuit 21 for control of a relay 22 which has contacts 23,24 as clarified below for connection of the motor 25 with field coils L1 and L2 to the electric power supply through a rectifier bridge PN1.

In the path of the signal output from the generator 18 to be applied to the detector 19 is connected, through a condenser C2, the sensor plate 16.

Once the switch 13 is operated, the contact or near proximity of a hand, even a gloved hand, with the plate 16 raises the capacitance of the plate 16 absorbing more of the signal from generator 18. This causes a decrease in the level of the signal reaching the detector 19, since part of it is absorbed by the operator's ground. This decrease is then detected by the comparator 20 which, upon passage of its reference operation threshold, through the amplifier 21 commands energizing of the relay 22.

If the operator removes his hand from the sensor 16, a greater proportion of the signal emitted by the generator 18 reaches the detector 19 and thence the comparator 20 which, upon passage of the reference deactivation threshold, de-energizes the relay. In this condition the motor is disconnected from the power supply and short-circuited through the diode D4 to produce an effective braking action caused by the electromotive counterforces induced in its windings.

The circuit also comprises inhibition means which prevents restarting of the motor simply by touching of the sensor again. A feedback modifies the reference activation threshold of the comparator so that it is impossible to pass this threshold even by touching the sensor 16. To bring back the circuit to operating condition it is then necessary to release the switch 13 and then restart it.

The power circuit 17 is provided by a resistor R16 causing a voltage drop from the voltage value at 14 to the value required for Vcc. A diode D2 converts the alternating voltage thus reduced into a pulsing voltage which is levelled by a condenser C6 and stabalized at the value Vcc by a Zener diode D3.

The generator 18 comprises an operational amplifier IC1 providing through a feedback network made up of resistors R1, R2, R3, R4 and R5 and capacitor C1, a square-wave signal having a substantially known diagram.

The square-wave signal thus produced is sent through a resistor R6 to the detector 19. The detector 19 comprises a shunt condenser C3 at whose output are present positive and negative pulses coinciding with leading and trailing edges of the square wave. A subsequent diode DI eliminates the positive pulses and sends the negative ones to an integration condenser C4 and, through a resistive divider R7, R8, R9, to a second integration condenser C5. In this manner at the ends of C5 is present a substantially direct voltage Vin proportional to the amplitude of the square-wave signal input to the detector 19. In particular, if there is a decrease of the signal amplitude, because it is partly absorbed by the operator's hand near the sensor 16, the voltage at the ends of C5 increases and vice versa.

The voltage Vin is applied to the input of a comparator comprising a second operational amplifier IC2, whose other, reference, input is supplied with a reference voltage Vr taken from Vcc by a resistive divider comprising resistors R10 and R11.

When Vin is greater than Vr the output of the comparator is near OV. Thus pilot transistor Q1 is disabled so that TRIAC Q2 is enabled and the relay 22 is energized. By selecting appropriately the threshold of Vr the tool starts as required upon approach and/or touching of the sensor 16 by the user.

Upon withdrawal of the user's hand from the sensor 16, the voltage Vin decreases until it reaches a value lower than the reference voltage Vr. The output of the comparator thus reaches a level near the voltage Vcc and, with the transistor Q1 thus becoming conductive, the TRIAC Q2 is shut off, de-energizing the relay 22 so as to short circuit the motor as described above.

To prevent restarting of the motor merely by retouching or reapproaching the plate 16, the comparator circuit 20 is supplied with a hysteresis by a feedback resistor R12. Indeed, when the output of the comparator is low the resistor R12 is practically in parallel with R11, lowering the reference voltage Vr. When the output of the comparator is high the resistor R12 is practically in parallel with R10, raising the reference voltage Vr.

With an appropriate choice of values of the resistors R10, R11 and R12, when the output of the comparator goes to a high level, the reference voltage Vr goes to a level so high that it is always greater than the voltage Vin obtained by touching the sensor 16. That is to say, when the motor is de-energized by the comparator going high (Vcc), the reference voltage Vr is immediately raised and thereafter the motor cannot be restarted. It can only be restarted when the reference voltage is low which it is as long as there is a low output from the comparator. This condition can only be achieved by switching on switch 13 when the hand is on sensor 16 and not vice versa.

In other words, the circuit must be disconnected from the power supply by turning off the switch 13 and then turning it back on after the hand has been repositioned on the sensor 16. The comparator, having in this case Vr at a lower level and less than the voltage Vin, has low output and hence the relay can be energized, starting the tool motor.

A tool equipped in an innovative manner with a circuit as described provides high safety and ensures prompt deactivation of the motor and quick braking upon withdrawal of the hand from the grip. Protection is also supplied this way in case of loss of grip by the operator because of distraction or sticking of the tool.

In addition, the impossibility of sudden starting of the tool is ensured; for example, it does not start if its power supply cable is connected to the mains with the switch 13 in the on position, or is inadvertently operated, without the hands in the gripping position.

Given the operating principle of the system the effectiveness of the sensor plate is unaffected by oxidation or dirt on its surface, unlike the above mentioned embodiments of the known art. The plate can be provided in any conducting material, even covered with insulating material or even directly buried in the structure of the tool case (if said case is of insulating material) since direct contact between the operator and the conducting part of the sensor is not necessary.

Naturally the above description of an embodiment applying the innovative principles of the present invention is given merely by way of example and therefore is not to be taken as a limitation of the patent right claimed here. For example, as mentioned above the tool can be of types quite different from those shown in the figures and have different configurations and arrangements of the sensor plates. Hedge-trimmers are a particular example of potential application where perhaps two sensors 16 could be employed, a hand being required in the proximity of each before operation can commence.

## Claims

**1.** Portable tool (10) driven by an electric motor (25) and of the type comprising at least one grip (12) on which is present at least one sensor element (16) made of conductive material connected to an electronic circuit (15) for operation, upon detection of a hand holding said grip, of means (21,22) of consent for power supply to the motor through a manual power supply switch (13),
characterized in that the electronic circuit comprises a signal generator (18) sending a relatively high frequency signal to the input of means (19,20) of measurement of its amplitude, the sensor element being connected along the signal path between the generator and input of the measurement means so as to induce transfer of part of the signal upon a hand holding the grip near the sensor element, the measurement means sending an operation command to the consent means upon detection of a lowering of the amplitude of the signal produced by said transfer.

**2.** Tool in accordance with claim 1 characterized in that the electronic circuit further comprises means (R12) of inhibition of activation of said consent means, said inhibition means becoming activated when said manual switch is activated and upon detection of a rise in the amplitude of the signal following said lowering.

**3.** Tool in accordance with claim 1 or 2 characterized in that the consent means comprises a relay (22) with exchange contacts (23,24) in series with the motor power supply and which relay closes upon receipt of said operation command.

**4.** Tool in accordance with and preceding claim characterized in that said measurement means comprises a detector (C3) to which is applied the generator signal and supplying at the output (Vin) a direct voltage which is a function of the amplitude of said signal, said direct voltage being applied to a comparator (IC2) together with a predefined threshold voltage, (Vr), said comparator supplying said operation command to the consent means when said direct voltage passes said threshold voltage.

**5.** Tool in accordance with claim 4 characterized in that said function is inverse so as to supply said direct voltage in inverse proportion to the amplitude of the applied signal and so that said comparator supplies said operation command when said direct voltage exceeds said threshold voltage.

**6.** Tool in accordance with claim 5 characterized in that the sensor comprises in series, an RC shunt network, a negative half-wave rectifier and an RC integration network.

**7.** Tool in accordance with claim 5 or 6 characterized in that the comparator is an operational amplifier with its negative input connected to said inversely proportional direct voltage and its positive input connected to said predefined direct threshold voltage.

**8.** Tool in accordance with any of claims 4 to 7 when dependent on claim 2 characterized in that the inhibition means comprise a variation circuit for the predefined threshold voltage to take it outside the limits of said direct voltage.

**9.** Tool in accordance with claim 8 characterized in that the variation circuit comprises a hysteresis network for the comparator.

**10.** Tool in accordance with claims 7 and 9 characterized in that the hysteresis network comprises a feedback resistor (R12) arranged between the operational amplifier output and its positive input.

**11.** Tool in accordance with any preceding claim characterized in that there are provided means for braking the motor activated by the absence of the consent means operation command.

**12.** Tool in accordance with claims 3 and 11 characterized in that said braking means are provided by the relay exchange contacts closing upon cessation of power supply thereto and short circuiting the windings of the closed ring motor to generate braking forces by means of counter electromotive force.

**13.** Tool in accordance with any preceding claim characterized in that the relatively high frequency signal is of the order of 500kHz.

**14** Tool in accordance with any preceding claim characterized in that the relatively high frequency signal is a substantially square wave.

**15.** Tool in accordance with any preceding claim characterized in that the manual switch (13) also activates the electronic circuit power supply (17).
